# EUROPEAN PATENT APPLICATION

(11) **EP 1 505 667 A2**
(43) Date of publication of application: **09.02.2005**
(21) Application number: 04254440.3
(22) Date of filing: 22.07.2004
(51) Int. Cl.: H01L 51/40, B41M 1/26

(54) **Methods and fixtures for facilitating handling of thin films**

(30) Priority: 24.07.2003 US 625171
(71) Applicant: GENERAL ELECTRIC COMPANY, Schenectady, NY 12345 (US)
(72) Inventor: Duggal, Anil Raj, Niskayuna New York 12309 (US); Schaepkens, Marc, Ballston Lake New York 12019 (US); McConnelee, Paul Alan, Schenectady New York 12306 (US); Yan, Min, Schenectady New York 12306 (US)
(74) Representative: Szary, Anne C.

(57) **Abstract**

An apparatus (10) comprises a fixture comprising at least one inner member (14) and at least one outer member (16). The fixture (10) is configured to secure a film (12) between the at least one inner member (14) and the at least one outer member (16). The secured film (12) can be further processed to give a processed film. Further, the processed film, secured in the fixture (10), can undergo additional manufacturing steps to produce processed articles. The apparatus (10) and methods described herein are useful for producing a variety of articles, such as micro-electronic and optoelectronic devices.

## Description

The present invention relates generally to apparatuses and methods for facilitating the securing of thin films. Furthermore, the present invention also relates to a fixture that is used for securing thin films for further processing. In particular, the present invention relates to such a fixture for securing thin films for producing thin-film electronic devices.

Opto-electronic devices, such as organic electro-luminescent devices ("OELDs") and active-matrix liquid-crystal displays (LCDs) offer a path to low-cost, large-area displays and lighting devices by virtue of their simple fabrication techniques. In display applications OELDs potentially have the ability to display a wide range of colors while using little energy, and therefore offer design and performance advantages, including clearer images, crisper video, and thinner designs for use in devices such as digital cameras, mobile phones, and personal digital assistants. Additional benefits over conventional technologies, such as those based on vacuum tubes include higher contrast for superb readability in most lighting conditions, faster response time to support streaming video, and wide angle viewing angles for superior ergonomics, making them ideal for such applications as in surface-mounted and portable products.

Conventional OELDs have generally been built on glass substrates. Recently, efforts have been devoted to fabricating these devices on plastic substrates, since glass substrates are not suitable for certain applications where flexibility is desired. Moreover, manufacturing processes involving large glass substrates suffer from yield loss due to glass breakage and thus result in high manufacturing cost. In addition, glass films of a given thickness are heavier than plastic films. Thus, there is a clear benefit for utilizing plastic substrates. However, a drawback of plastic substrates is that they are difficult to handle in traditional manufacturing processes. To accommodate handling of plastic substrates, adhesives have been used for mounting plastic films on glass substrates. However, the use of plastic films adhered to glass does not avoid the glass breakage issue and further introduces additional handling steps that can cause damage of the finished devices.

Therefore, there is a need for a suitable apparatus that may be used for handling plastic films such that they can be securely processed using traditional manufacturing techniques for producing opto-electronic devices.

### BRIEF SUMMARY OF INVENTION

The present invention provides an apparatus for securing a film. In one aspect, the apparatus comprises at least one inner member and at least one outer member. The inner member is disposed in a space defined by the outer member to secure the film.

In another aspect of the present invention, a fixture for securing a plastic film comprises at least one inner member and at least one outer member, which are configured to secure the film disposed between the inner member and the outer member.

In still another aspect of the present invention, such a secured film is further processed in a manufacture of electronic devices.

In yet another aspect of the present invention, a method for securing a plastic film comprises: disposing the film between at least one inner member and at least one outer member of a fixture, and moving the inner member and the outer member together to secure the film.

In still another aspect of the present invention, a method for producing a processed film comprises: disposing a film between at least one inner member and at least one outer member of a fixture, moving the inner member into a space within the outer member to produce a secured film, exposing the secured film to at least one processing step, and moving apart the inner member and the outer member to release the processed film..

In yet another aspect of the present invention, a method for producing a processed article comprising a film is provided. The method comprises: disposing the film between at least one inner member and at least one outer member of a fixture, moving the inner member into a space within the outer member to produce a secured film, building the processed article on the secured film, and moving apart the inner member and the outer member to release the processed article.

In yet another aspect of the present invention, a manufacturing system for producing a processed film comprises a film dispensing station; a film fixturing station, a film processing station, and a film de-fixturing station. The film fixturing station comprises at least one fixture comprising at least one inner member and at least one outer member. The film is disposed between the inner member and the outer member, and the inner and outer members are configured to securely hold the film.

Other features and advantages of the present invention will be apparent by way of example from the following detailed description of an embodiment of the invention and the accompanying drawings in which like numerals refer to like elements.

### BRIEF DESCRIPTION OF THE DRAWINGS

FIGURE 1 is an exploded perspective view of a film processing system;
FIGURE 2 is an assembled perspective view of the film processing system of FIGURE 1;
FIGURE 3 is a sectional view of a portion of the film processing system sectioned along line 3-3 of FIGURE 2;
FIGURE 4 is a transverse sectional view of a first alternative film processing system;
FIGURE 5 is a transverse sectional view of a second alternative film processing system;
FIGURE 6 is a transverse sectional view of a third alternative film processing system comprising a supporting inner member;
FIGURE 7 is a partial sectional view of a fourth alternative film processing system;
FIGURE 8 is a partial sectional view of a fifth alternative film processing system;
FIGURE 9 is an exploded perspective view of a film processing system adapted to a conventional device processing system used for glass substrates;
FIGURE 10 is an exploded perspective view of a film processing system comprising multiple fixtures; and
FIGURE 11 is a flowchart illustrating exemplary steps for processing films by means of the film processing systems illustrated in the previous FIGURES.

### DETAILED DESCRIPTION OF THE INVENTION

Throughout this application the terms "inner member" and "outer member" mean one or more inner members and one or more outer members, respectively. The term "fixture" means a combination of at least one inner member and at least one outer member. It should be understood that the drawings accompanying this disclosure are not drawn to scale. The term "de-fixturing" refers to the process whereby the inner and the outer members are disengaged from each other to release the processed film.

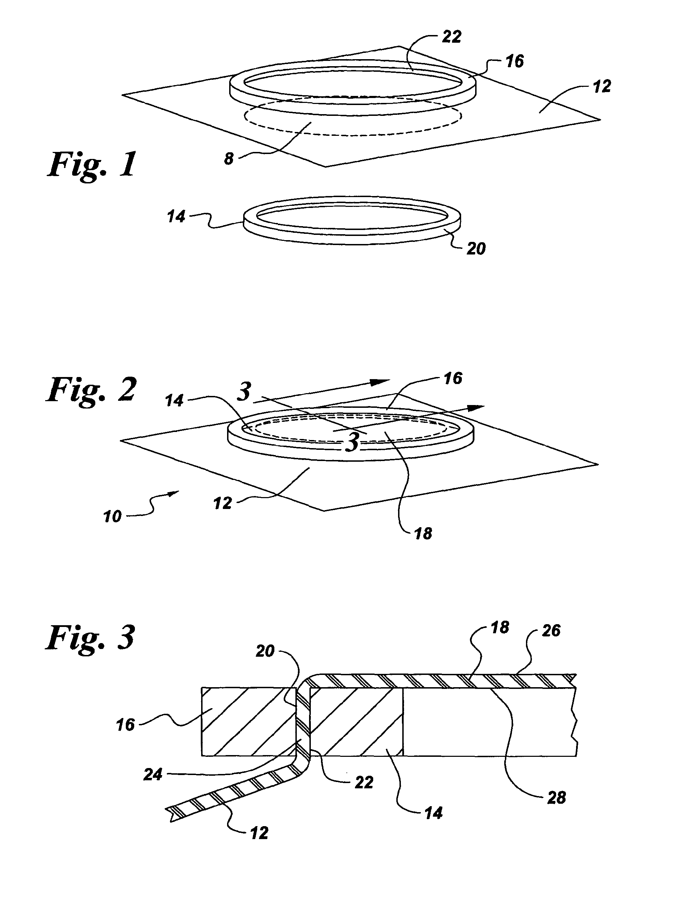

The present invention provides an apparatus for securing films, such as thin plastic films. Furthermore, the invention is useful for facilitating the production of electronic devices that comprise such thin plastic films. In one aspect of the invention, the apparatus comprises a film and a fixture comprising at least one inner member and at least one outer member, wherein the film is held securely between said members. Figure 1 illustrates the first embodiment of the invention. The apparatus is a film processing system 10 comprising a film 12 disposed between a fixture comprising an inner member 14 and an outer member 16. The inner member 14 has a smaller diameter than the outer member 16. In other embodiments, the fixtures can assume shapes other than the circular ones disclosed herein as long as the inner member fits in the space bounded by the outer member. The fixture comprising the inner and the outer member is configured such that when a film is disposed therebetween, and the inner member is moved into the space bounded by the outer member, the film gets secured. Figure 2 shows an assembled perspective view of the film processing system 10 where the inner member 14 and outer member 16 are brought together coaxially. This action results in securing of the film 12. Figure 3 illustrates a sectional view of a portion of the film processing system 10 sectioned along line 3-3 of Figure 2. The secured film so produced is firmly held in place by the fixture between the outer surface 20 of the inner member 14 and the inner surface 22 of the outer member 16. This technique enables one to carry out a variety of further processing options on the work area 18 created on the surface of the secured film, thus further extending the utility of the fixture and the apparatus.

In an embodiment, the film used with the film processing system 10 typically has a thickness of about 2 X 10⁻⁵ meter to about 8 X 10⁻⁴ meter. The film comprises material selected from the group consisting of thermoplastic polymers and thermoset polymers. The film may comprise a single layer or a plurality of layers (such as for example, laminar layer of different polymer films) of different thermoset or thermoplastic homopolymers, copolymers, blends, or derivatives thereof. Non-limiting examples of the thermoplastic polymers include polymers selected from the group consisting of polycarbonates, polyesters, polyestercarbonates, polyamides, polyimides, polyolefins, polyphenylene ethers, polyamideimides, polyethersulfones, polyacrylates, styrenic polymers, silicones, epoxy resins, silicone-functionalized epoxy-resins, copolymers, derivatives, and blends thereof. In an embodiment, the thermoplastic polymer is selected from the group consisting of polybutylene terephthalate; polyethylene terephthalate; styrene-acrylonitrile copolymer; styrene-methacrylonitrile copolymer; acrylonitrile-butadiene-styrene copolymer; acrylonitrile-alpha-methylstyrene-butadiene copolymer; polyarylate copolymers containing repeating units derived from isophthalic acid, terephthalic acid, resorcinol, and bisphenol A; and polycarbonates comprising repeating units derived from at least one of bisphenol A, 1,3-bis(4-hydroxyphenyl)-1-methyl-4-isopropylcyclohexane, and 2,8-bis(4-hydroxyphenyl)-1-methyl-4-isopropylcyclohexane; and blends of the foregoing polymers. In an embodiment, the film generally has a refractive index from about 1.05 to about 2.5.

Depending upon the nature of the film, the inner and the outer members can be maintained at a temperature selected from the group consisting of sub-ambient, ambient, and above-ambient temperature. In some situations, when film 12 is secured at elevated temperatures using heated inner member 14 and heated outer member 16 that are made of a metal, the secured film can sag as a result of which further processing can become problematic. This problem is exacerbated as the temperature increases. One of the reasons for this sagging is the mismatch in the coefficients of thermal expansion ("CTEs") of the film and the inner/outer members. One potential solution to overcome this problem is to use inner member 14 and outer member 16 that are made of a polymer material having an appropriately high glass transition temperature. In one embodiment, the film and the inner and outer members, 14 and 16, respectively, comprise the same polymer material. In another embodiment, the film, and the inner and outer members, 14 and 16, respectively, have substantially the same thermal properties, such as CTE. The term, "substantially the same thermal properties" means that no excessive stresses are generated in the polymeric film that would induce failures in the coatings or devices that are subsequently being deposited on the polymeric film. In an embodiment, the film, and the inner and the outer members, 14 and 16, respectively, have substantially the same coefficient of thermal expansion from about 5 parts per million to about 150 parts per million, per degree Kelvin. The fixture comprising the inner member 14 and the outer member 16 forms the heart of the apparatus disclosed herein. The inner member 14 and the outer member 16 generally can be of any shape. In one embodiment, they have substantially the same shape. Non-limiting examples of shapes include circular, rectangular, square, oval, elliptical, and polygonal shapes with rounded edges. The presence of sharp edges is not desired for handling films, especially thin films of thickness of up to about 8 X 10⁻⁴ meter as they may tear or puncture when they are secured with such a fixture. In an embodiment, the inner side of the outer member and the outer side of the inner member contacting the film have rounded comers, as shown in Figure 3. Generally, the inner member has a cross sectional dimension smaller than that of the outer member. The difference in cross sectional dimension between the inner and the outer members is selected primarily based on the thickness of the film. More generally, the difference in cross sectional dimension between the inner and the outer members should be such that the members should hold the film firmly when the film is disposed between the inner and the outer members. For example, for a fixture comprising a circular inner and outer member, for a given film thickness, the smaller the diameter difference between the inner and the outer members, the tighter the secured film is held in the fixture.

The inner member 14 and the outer member 16 comprising the fixture can be made of any type of material. In an embodiment, the material is independently selected from the group consisting of polymers, metals, and fiber-reinforced materials. Non-limiting examples of materials include metals and metal-based alloys, such as iron, aluminum, nickel, copper, stainless steel, monel, and inconel; glass, and ceramics. The polymers are selected from the group consisting of thermoplastic polymers and thermoset polymers. Thermoplastic include polymers that can be used include those selected from the group consisting of polycarbonates, polyesters, polyestercarbonates, polyamides, polyimides, polyolefins, polyphenylene ethers, polyamideimides, polyethersulfones, polyacrylates, styrenic polymers, silicones, epoxy resins, silicone-functionalized epoxy-resins, copolymers, derivatives, and blends thereof. In an embodiment, the thermoplastic polymers comprising the inner and outer members are selected from the group consisting of polybutylene terephthalate; polyethylene terephthalate; styrene-acrylonitrile copolymer; styrene-methacrylonitrile copolymer; acrylonitrile-butadiene-styrene copolymer; acrylonitrile-alpha-methylstyrene-butadiene copolymer; polyarylate copolymers containing repeating units derived from isophthalic acid, terephthalic acid, resorcinol, and bisphenol A; and polycarbonates comprising repeating units derived from at least one of bisphenol A, 1,3-bis(4-hydroxyphenyl)-1-methyl-4-isopropylcyclohexane, and 2,8-bis(4-hydroxyphenyl)-1-methyl-4-isopropylcyclohexane; and blends of the foregoing polymers.

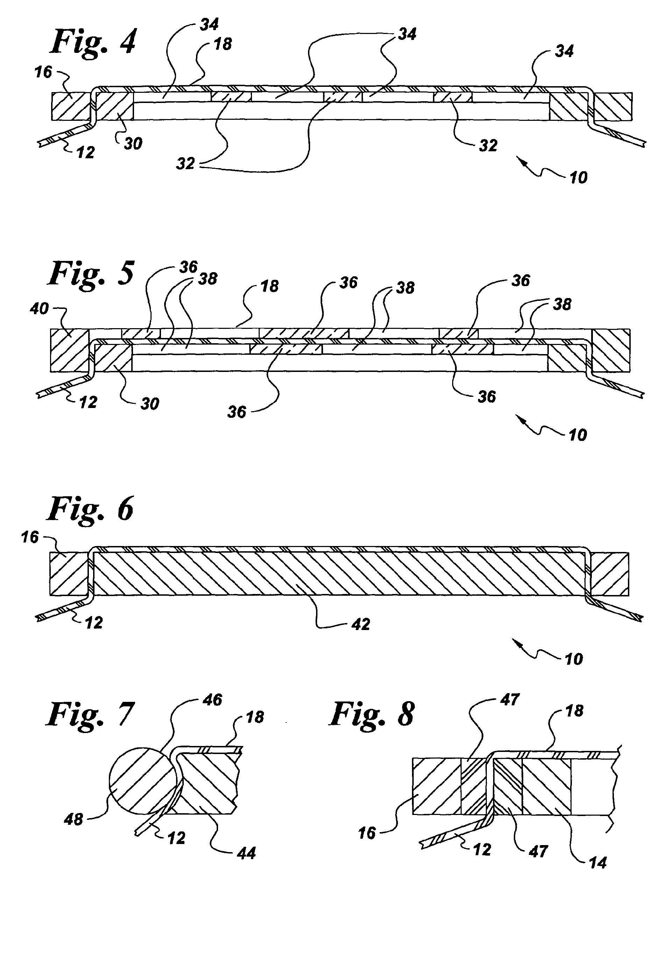

The apparatus described hereinabove for securing a film can also be modified suitably to allow for various masking techniques to be implemented on the secured film for building thin-film electronic devices theron. In several embodiments, the inner member, or the outer member, or both members comprise one or more mask portions and aperture portions. In an embodiment, the mask is radiation mask. Two embodiments of such a modified apparatus are shown in Figures 4 and 5. Figure 4 illustrates a transverse sectional view of a first alternative film processing system depicting a film 12 disposed between an outer member 16 and an inner mask member 30 having a mask portion 32 and aperture portions 34. The work area 18 of the film secured with such a film processing system will thus have apertures (or exposing regions) 34 which can be exposed from the topside of the work area 18 to different types of coating and radiation sources for further processing. Figure 5 illustrates a transverse section view of a second alternative film processing system depicting a film 12 disposed between an outer member 40 and an inner member 30. Both the inner and the outer members have mask portions 36 and apertures (or exposing regions) 38. After being secured between the inner member 30 and outer member 40, the secured film can be exposed from the bottom of work area 18, or from the top of work area 18 through apertures 38 to different coating, etching, ablation and radiation sources for further processing using techniques, such as patterning using photolithography (described further below), whereby geometric shapes on a mask can be transferred on to the surface of the secured polymer film. In addition, the inner member can also have various patterns of grid work, which will also act as a masking device.

Photolithography is a technique generally used for patterning semiconductors and other components used in various applications, such as for example, sensors and micro-electromechanical systems. Either standard photolithography or mask-less photolithography techniques can be employed. Standard photolithography is generally carried out using a four-step process. For example, the secured plastic film, either uncoated or coated with additional layers, is first coated with a negative or a positive photoresist material. A suitable example of a negative photoresist material is a soluble polyamic acid (obtained for example, by reaction of a diamine with a dianhydride) having a suitable photo-polymerizable group, which upon photoexposure will produce the insoluble polyimide material. Next, the photoresist is exposed to light through a suitable photo-mask to selectively allow pre-determined areas of the photoresist coating to undergo polymerization to the polyimide. In the next step, sometimes called the development step, the non-polymerized, soluble photoresist portions are removed by washing with a suitable solvent, thereby leading to a pattern defined by the photo-polymerized areas. In the final step, also sometimes called the curing step, the secured plastic film comprising the patterned area is baked in an oven or a hot plate, which leads to formation of a patterned, cross-linked polyimide structure on the secured plastic film. After this cross-linked polyimide structure is formed on the secured plastic, additional process steps, such as etching, ablation or deposition, will be performed to further form a functional device on the secured plastic film.

The inner member 14 and the outer member 16 can have a variety of other structural features to permit further customized processing of the secured film thus obtained. In one embodiment, the inner member 14 comprises a cross-sectional surface generally comprising the same material as the inner member. Furthermore, the cross-sectional surface can comprise a plurality of apertures for allowing energy such as heat or radiation to impinge on the secured film. Figure 6 shows a transverse sectional view of a third alternative film processing system comprising a supporting inner member 42. The supporting inner member is an inner member where the cross-sectional area comprises a solid surface. Such a solid surface not only provides a firm support to the secured film but also permits a variety of imprinting operations to be carried out on the appropriate exposed surface of the secured film. In one embodiment, the supporting inner member comprises one or more holes or apertures. These holes or apertures are useful in expelling compressed air created when the supporting inner member presses against the film due to the pressing of the inner and the outer members against each other.

Other functional modifications of the fixture for achieving potentially superior securing and fixing of the film are also possible. In one embodiment, at least one of the inner and outer members comprises a liner that is configured to provide better grip to the film disposed between the inner and outer members. The liner in many embodiments can be made of any type of a metal or polymer. Since polymers are generally softer than metals, liners made of appropriate polymer materials also provide enhanced protection to the thin secured films from being torn or otherwise damaged. Several different mechanical designs for the liner are possible. In an embodiment, the liner has a design selected from a right circular cylinder, a concave, a convex, a tongue-in-groove, and a press-fit design.

In another embodiment, the inner and outer members of the apparatus can also have a variety of contoured shapes with an interface member disposed between the inner and the outer members. In one embodiment, as illustrated in Figure 7, the edge-contoured inner member 44 can be used with an appropriately tubular edge-contoured outer member 48, and a suitably contoured interface member 46 disposed between the edge-contoured inner member and the edge-contoured outer member. When a film is disposed between such an inner and outer member, and the inner and outer members are moved towards each other, the interface member 46 facilitates in securely holding the film 12. An example of an edge-contoured outer member is a circular outer member having a groove and an O-ring made of a material capable of elastic deformation straddling the groove along the circumference of the groove acting as the interface member. Such an outer member when moved against a suitably edge-contoured inner member will effectively secure a film placed between the inner and the outer member. The O-ring will also be effective in handling delicate films by minimizing or eliminating tearing of the film during the securing process. In another embodiment, as illustrated in Figure 8, the outer edge of the inner member 14 and the inner edge of the outer member 16 can be bonded with other materials which forms interface member 47, which will facilitate handling delicate films, especially those of thickness less than about 8 X 10⁻⁴ meter. Examples of such materials that can be used for the interface member 47 for include a variety of polymers, such as those described above. In an embodiment, the materials comprising the interface member 47 that can be bonded to the inner edge of the outer member 16 and the outer edge of the inner member 14 can be the same or different. They can be selected based on their thermal properties, such as glass transition temperature and coefficient of thermal expansion, as well as other physical properties, such as coefficient of friction, hardness, and other suitable properties.

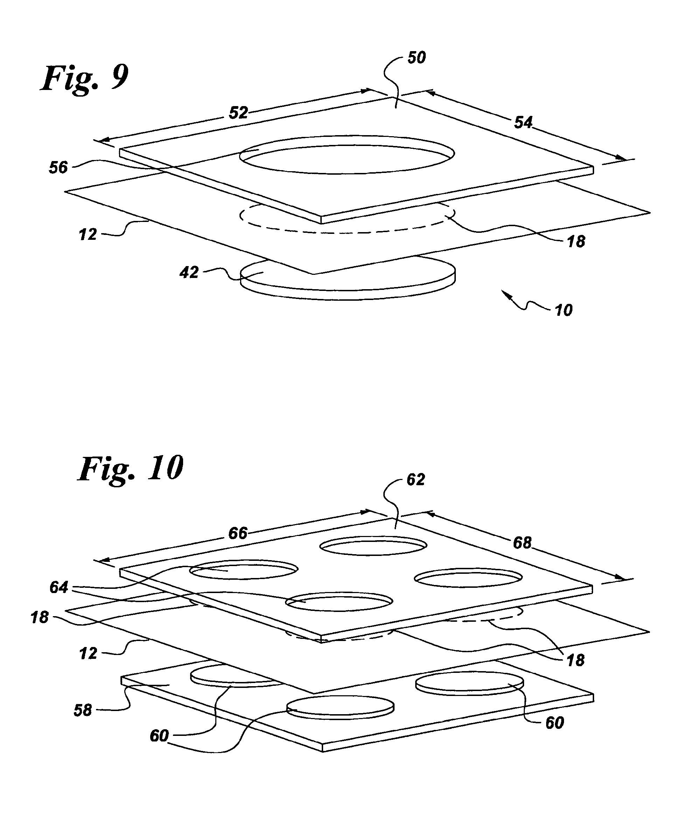

The techniques and ideas described above can also be adapted for use with a conventional device processing system, such as one that uses glass substrates. The upper member can, in general be of any shape having a first dimension and a second dimension. The inner member is suitably contoured with respect to the outer member such that a film can be secured uniformly when the inner and outer members are moved against each other. Figure 9 illustrates one embodiment of such an adaptation where the processing system-adapted outer member 50, having a first dimension 52 and a second dimension 54 is contoured with aperture 56 to conform to the contour of the supporting inner member 42. A film 12 disposed between such an upper (hereinafter sometimes also called "outer") member and a lower (hereinafter sometimes also called "inner") member can be secured by moving the upper and the lower member towards each other. Several variants of the above arrangement are possible depending upon the nature of the conventional processing system, such as those for processing glass substrates, available for adaptation. In one embodiment, the upper member can be part of a fixed system against which a movable inner member can be pressed. In another embodiment, the inner member can be part of a fixed system against which a movable outer member can be pressed. In both cases, a film disposed between the inner and outer members can be secured uniformly. The techniques described hereinabove are particularly advantageous for low cost adaptation of conventional glass film processing systems of various sizes to secure the plastic films disclosed herein and create work areas of any shape. One can extend the above concept to another adaptation technique where a plurality of fixtures can be created to create a plurality of work areas on a given film. Figure 10 illustrates this embodiment with an example which shows multiple work-piece upper member 62 having a first dimension 66 and a second dimension 68, has four circular apertures 64, and the multiple work-piece base (or lower) member 58 has four circular supporting inner members 60, which are capable of supporting the film 12. This arrangement leads to creation of four work areas 18 on the secured film for further processing.

The fixtures comprising the inner and outer members as described above are prepared using methods comprising at least one of injection molding, stamping, machining, extruding, and cutting a fixture material. The type and sequence of the methods to be used depends upon the nature of the fixture material (determined by factors such as thermal stability and processibility) of which the inner and the outer members are made.

The techniques for securing plastic films, as described above, are useful for producing a processed film. The processed film is a film that after being secured using the fixture of the invention further undergoes one or more processing steps (as discussed in detail below) before being released from the fixture. The processed film can then be used for building a variety of devices.

Processing of the secured film can be accomplished by a method selected from the group consisting of coating, patterning, thermal treatment, and radiation treatment. The coating process can be carried out using a variety of techniques, such as deposition techniques, powder coating, spin coating, printing by screen inkjet printer, deposition by doctor blade, and spray coating. Non-limiting examples of deposition techniques include plasma-enhanced chemical-vapor deposition, radio-frequency plasma-enhanced chemical-vapor deposition, expanding thermal-plasma chemical-vapor deposition, reactive sputtering, electron-cyclotron-resonance plasma-enhanced chemical-vapor deposition, and inductively coupled plasma-enhanced chemical-vapor deposition. Radiation treatment comprises irradiating the secured film with a radiation selected from the group consisting of electron beam, ion beam, ultraviolet light, visible light and infrared light radiation. The mask that may be used for defining the area of the secured film to be exposed to the radiation can have various shapes, sizes, and different degrees of grayscale. In addition to the processing options described above, other types of processing steps, such as reactive ion etching, with or without various masking techniques can also be used. Any appropriate combination of the aforesaid processing steps can also be used.

Ultra-high barrier coatings, such as multi-layer barrier coatings or hybrid inorganic/organic barrier coatings with a graded composition, can also be applied on the surface of the secured film. Ultra-high barrier coatings are used to reduce diffusion rates of reactive materials in the environment, such as oxygen and water vapor. Plastic films having such barrier coatings are very useful as flexible substrate for the manufacture of OELDs having long lifetimes. The active OELD may also be formed directly on top of the secured, barrier coated, plastic substrate through the deposition of an organic electro-luminescent layer and at least two electrode layers, of which at least one is substantially transparent. Additional organic electronic layers, such as hole transport or electron transport layers, may be included in the OELD structure as well.

The method of producing the processed film can further be extended to a method for producing processed articles, such as micro-electronic and opto-electronic articles. The processed film prepared as described above is first secured using the fixture comprising the inner and the outer members to provide the secured processed film. Then the article is mounted on the secured processed film to produce the processed article, which is then released by moving apart the inner and the outer members of the fixture. Non-limiting examples of processed articles that can be prepared by this technique include liquid crystal displays, organic electro-luminescent displays, flat panel displays, electro-chromic devices, photovoltaic cells, and other micro-electronic devices, such as thin-film transistors, thin-film capacitors, and micro-electronic switches.

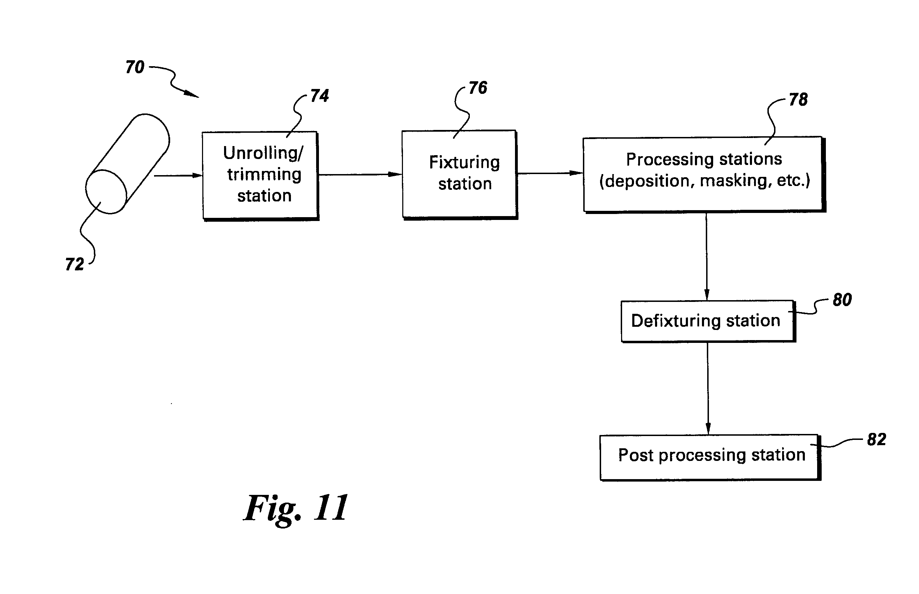

The ideas and techniques described above can be advantageously used for designing a commercial scale film processing system to produce opto-electronic devices. Figure 11 illustrates the flow chart for one embodiment of such a film processing system. The processing method 70 comprises film dispensing station 72, which feeds to unrolling/trimming station 74, which then dispenses either a continuous or a discontinuous portion of the film to the fixturing station 76. In an embodiment, the film dispensing station comprises at least one of a film cutting device, film interleaving device, film corner rounding device, film-slitting device, die cutting device, hole drilling device, and padding device. A film-slitting device is used for preparing films of appropriate thickness by suitably slitting thicker films or sheets. The fixturing station 76 secures the film by disposing it between the inner and outer members of the fixture, and the secured film then is taken to processing station 78, where the film is subjected to one or more processing steps, such as for example, masking, depositing, coating, and mounting an article on the secured processed film. When an article is mounted on the secured processed film, it leads to the production of a processed article, as described previously. The processed film or the processed article is next taken to defixturing station 80, where the inner and the outer members of the fixture are generally moved apart from each other to disengage the processed film or the processed article as the case may be.

In an embodiment, the processing method 70 can be adapted suitably for batch-wise or continuous processing of the film. In a batch-wise operation, the fixturing step to secure the film at fixturing station 76 is done batch-wise by taking individual pieces of plastic film from the unrolling or trimming station 74. The secured film is then processed and de-fixtured as described previously. In one embodiment of a continuous operation, the fixturing and the subsequent processing and defixturing steps can be done sequentially on a continuously moving bed of the plastic film.

The techniques described above for fixturing plastic films are valuable for securing and applying thin polymer films, especially those with thickness of up to about 8 X 10⁻⁴ meter disposed on surfaces, such as glass surfaces, and processed subsequently for producing micro-electronic or opto-electronic devices. Existing fabrication tools used for producing LCDs and OELDs, such as tools for cleaning the substrate surfaces, coating, patterning, and processing, used in conventional equipment for processing glass substrates, do not need to be modified for processing plastic films. Thus, a saving in cost and an increase in speed of manufacturing plastic-based opto-electronic and other display devices are realized.

While specific preferred embodiments of the present invention have been disclosed in the foregoing, it will be appreciated by those skilled in the art that many modifications, substitutions, or variations may be made thereto without departing from the spirit and scope of the invention as defined in the appended claims.

## Claims

1. An apparatus (10) comprising:
a film (12); and
a fixture comprising at least one inner member (14) and at least one outer member (16),
wherein said at least one inner member (14) and said at least one outer member (16) (16) are configured to secure said film (12) therebetween.

2. The apparatus (10) of Claim 1, wherein said film (12) and said at least one inner member (14) and said at least one outer member (16) have substantially the same thermal properties.

3. The apparatus (10) of Claim 1, wherein at least one of said at least one inner member (14) and said at least one outer member (16) comprises one of at least one mask portion (32) and at least one aperture portion (34).

4. A fixture (10) for securing a film (12), said fixture (10) comprising:
at least one inner member (14); and
at least one outer member (16),
wherein said at least one inner member (14) is configured to fit in said at least one outer member (16) such that said at least one inner member (14) and said at least one outer member (16) together are capable of securing said film (12) therebetween.

5. The fixture (10) of Claim 4, wherein said at least one inner member (14) and said at least one outer member (16) comprise a liner, said liner being configured to grip said film (12) between said at least one inner member (14) and said at least one outer member (16); and said liner is disposed in a position selected from the group consisting of inner side of said at least one outer member (16) and outer side of said at least one inner member (14).

6. A method for securing a plastic film (12), said method comprising:
disposing said film (12) between at least one inner member (14) and at least one outer member (16) of a fixture (10); and
moving at least one of said at least one inner member (14) and said at least one outer member (16) toward the other member to secure said film (12) therebetween.

7. A method for producing a processed film (12), said method comprising:
disposing a film (12) between at least one inner member (14) and at least one outer member (16) of a fixture (10);
moving at least one of said at least one inner member (14) and said at least one outer member (16) toward the other member to secure said film (12) therebetween to produce a secured film (12);
exposing said secured film (12) to at least one processing step to produce a processed film; and
moving apart said at least one inner member (14) and said at least one outer member (16) to release said processed film from said fixture.

8. The method of Claim 7, wherein said processing is selected from the group consisting of chemical vapor deposition, physical vapor deposition, powder coating, spin coating, and spray coating.

9. A method for producing a processed article comprising a processed film (12), said method comprising:
disposing said processed film (12) between at least one inner member (14) and at least one outer member (16) of a fixture (10);
moving at least one of said at least one inner member (14) and said at least one outer member (16) toward the other member to secure said film (12) therebetween to produce a secured processed film;
disposing an article on said secured processed film to produce a processed article; and
moving apart said at least one inner member (14) and said at least one outer member (16) to release said processed article.

10. A manufacturing system (70) for producing a processed film, said system comprising:
a film dispensing station (72);
a film-fixturing station (76);
a film processing station (78); and
a film de-fixturing station (80);
wherein said film-fixturing station (76) comprises at least one fixture (10) comprising at least one inner member (14) and at least one outer member (16), and said at least one inner member (14) and said at least outer member (16) are configured to securely hold a film (12) therebetween.
